# EUROPÄISCHE PATENTSCHRIFT

(11) **EP 0 502 023 B1**
(45) Veröffentlichungstag und Bekanntmachung des Hinweises auf die Patenterteilung: **12.01.2000**
(21) Anmeldenummer: 90917132.4
(22) Anmeldetag: 27.11.1990
(51) Int. Cl.: C25D 5/54, C25D 5/56, C08G 61/12

(54) **METALLISIERUNG VON NICHTLEITERN**
METALLIZATION OF NON-CONDUCTORS
METALLISATION DE NON CONDUCTEURS

(30) Priorität: 28.11.1989 DE 3939676
(43) Veröffentlichungstag der Anmeldung: 09.09.1992
(73) Patentinhaber: ATOTECH Deutschland GmbH, 10553 Berlin (DE)
(72) Erfinder: MAHLKOW, Hartmut, D-1000 Berlin 41 (DE); BRESSEL, Burkhard, D-1000 Berlin 19 (DE)
(74) Vertreter: Effert, Udo, Dipl.-Ing.
(86) Internationale Anmeldenummer: DE9000920
(87) Internationale Veröffentlichungsnummer: WO9108324

(56) Entgegenhaltungen:
- Chemical Abstracts, Band 109, Nr. 20, November 1988, (Columbus, Ohio, US)

## Beschreibung

Die Erfindung betrifft ein Verfahren zum direkten Metallisieren von Nichtleitern, bei dem aus einer wässrigen, ggf. Lösungsvermittler enthaltenden Lösung von noch nicht leitfähigen Oligomeren, Monomeren oder verschiedenen Monomer-Gemischen oder Oligomer-Monomer-Gemischen aus der Gruppe der 5-gliedrigen Heterocyclen durch Kontakt mit an Nichtleitern adsorbierten Oxidationsmitteln an der Oberfläche des Nichtleiters fest haftende, unlösliche Hochpolymerprodukte abgeschieden werden, deren elektrische Leitfähigkeit ausreicht, um durch Anlegen eines elektrischen Stroms Metall aus galvanischen Bädern auf der Polymeroberfläche abzuscheiden.

Elektrisch leitfähige Heterocyclen-Polymere als Beschichtungen für Nichtleiter sind an sich bekannt, so aus den Schriften DE 3520980, DE 3132218 und DE 3535709 und des weiteren aus der EP 0206133. Hier wird beschrieben, daß mit Hilfe des monomeren Pyrrols unter Verwendung starker Oxidationsmittel Polypyrrol am Nichtleiter niedergeschlagen werden kann. Die Verwendung dieser leitend gemachten Nichtleiter unterliegt dem jeweiligen Anwendungszweck.

In einer weiteren Schrift (DE 3806884 C1) wird die Verwendung von Polymeren mit intrinsisch elektrischer Leitfähigkeit, gebildet aus dem Monomer und einem starken Oxidationsmittel, für die elektrische Durchkontaktierung von Leiterplatten beschrieben.

Die Lehre der Schriften EP 0206133 und DE 3806884 sind vom Einsatz starker Säuren und starker Oxidationsmittel abhängig und erfordern ein hohes Maß an technischem Know How, da die praktische Arbeitsbandbreite sehr schmal ist, um den gewünschten Erfolg herbeizuführen.

Als unerwünschte Nebenreaktion der verwendeten Heterocyclen ist bekannt, daß beispielsweise Pyrrol leicht zur Polymerisation unter Einwirkung von Licht oder Säuren neigt. Die Säuren vermögen innerhalb kurzer Zeit Polypyrrol aus dem Monomeren zu bilden, das als unlöslicher schwarzer Niederschlag ausfällt, welches amorph ist und sich technisch nicht mehr weiterverarbeiten läßt.

Aufgabe der vorliegenden Erfindung ist es, ein Verfahren bereitzustellen, bei dem lösliche, nicht leitfähige Derivate aus der Gruppe der 5-gliedrigen Heterocyclen eingesetzt werden, die mit milden Oxidationsmitteln in elektrisch leitfähige Polymere überführt werden unter Anwendung nur eines Verfahrensschrittes und bei Verwendung nur einer Lösung.

Die der Erfindung zugrundeliegende Aufgabe wird durch das in den Ansprüchen 1, 2 oder 3 gekennzeichnete Verfahren gelöst. Innerhalb der Unteransprüche 4-14 werden besondere Ausgestaltungsformen beschrieben.

Dem erfindungsgemäßen Verfahren kann eine Vorbehandlung der Leiterplatte vorgeschaltet sein. Auf die Leiterplatte, die aus Isoliermaterial besteht, wird als Oxidationsmittel beispielsweise eine Braunsteinschicht (Mangandioxid) aufgebracht. Dieses erfolgt zum Beispiel durch Tauchen der Leiterplatte in eine Kaliumpermanganatlösung, wobei auf der Leiterplattenoberfläche eine Reaktion des Leiterplattenmaterials mit dem Permanganat stattfindet. Mangan-(VII) wird zu Mangan-(IV) reduziert. Das Reaktionsprodukt bettet sich in die Poren der nichtleitenden Bereiche der Leiterplattenoberfläche ein oder wird von der Leiterplattenoberfläche adsorbiert. Durch die Oxidationsstufe +(IV) des Mangansist die Leiterplatte auf den nichtleitenden Bereichen allumfassend, also insbesondere innerhalb der Bohrlochwandungen, mit dem milden Oxidationsmittel Braunstein belegt. Dieser adsorbierte Braunstein ist durch Spülungen nicht mehr entfernbar und stellt das für das erfindungsgemäße Verfahren wirksame Oxidationsmittel dar.

Eine so vorbehandelte Leiterplatte wird nun nach dem erfindungsgemäßen Verfahren behandelt.

Durch Kontakt der so vorbehandelten Leiterplatte mit einer wässrigen, sauren und ggf. Lösungsvermittler enthaltenden Lösung von noch nicht leitfähigen Oligomeren, Monomeren oder Gemischen verschiedener Monomere oder Oligomer -/ Monomer - Gemische aus der Gruppe der 5-gliedrigen Heterocyclen wird diese mit einer festhaftenden, unlösliche Hochpolymerprodukte enthaltenden elektrisch leitfähigen Schicht überzogen.

Diese erfindungsgemäße Verfahrensweise bietet ggü. den erwähnten Verfahren verschiedene Vorteile:

Zum einen wird die leitende Polymerschicht in einer Prozessstufe unter Verwendung einer Lösung gebildet. Daher entfällt ein Verfahrensschritt, was hinsichtlich der Kosten des Verfahrens günstiger ist (geringere Investitionskosten der Metallisierungsanlage, geringerer Aufwand für die Prozessüberwachung , die Entsorgung verbrauchter Lösungen und die Lagerhaltung).

Darüber hinaus findet die Polymerisationsreaktion unmittelbar beim ersten Kontakt der Heterocyclen-Lösung mit der Substratoberfläche statt, so daß eine sehr kontrollierte Reaktionsführung ermöglicht wird. Dies führt u.a. dazu, daß die Heterocyclenverbindung nicht notwendigerweise in darauf folgende Prozesslösungen verschleppt werden muß, um in einem weiteren Reaktionsschritt zu polymerisieren. Daher wird beim erfindungsgemäßen Verfahren überschüssige Monomerenlösung, die nicht auf der Substratoberfläche zur Reaktion kommt, in diesen Folgeschritten nicht zu unerwünschter Schlammbildung führen, abgesehen davon, daß hierdurch auch ein unnötiger Chemikalienverbrauch mit der entsprechenden Notwendigkeit der Entsorgung überschüssiger verbrauchter Chemikalien vermieden wird.

Die Benetzung der Substratoberfläche mit der Heterocylenlösung ist beim erfindungsgemäßen Verfahren, anders als bei den in der Literatur beschriebenen Verfahren, kein kritischer Schritt. Wird zunächst auf der Substratoberfläche ein Oberflächenfilm gebildet, der in einem weiteren Prozessschritt durch eine Oxidationsreaktion in das leitfähige Polymere umgewandelt wird, so müssen die Prozessbedingungen (Viskosität der Monomerenlösung, Oberflächenrauheit des Substrates, Überhebzeit zwischen den Prozessschritten Monomerenbenetzung und Oxidation u.a.) sehr genau bestimmt und eingestellt werden, um eine leitfähige Schicht mit geeigneten Eigenschaften zu erreichen.

Dies ist beim erfindungsgemäßen Verfahren nicht erforßerlich, da Benetzung mit Monomer- bzw. Oligomerlösung und Oxidationsreaktion in einer Prozesslösung erfolgen.

Ein weiterer Vorteil des erfindungsgemäßen Verfahrens besteht in der Verwendung von sauren Lösungen zur Bildung der leitfähigen Polymerenschicht. Dadurch werden insbesondere in der Leiterplattentechnik die auf den Kupferflächen entstandenen Oxidfilme entfernt, so daß das oxidierend wirkende Kupfer(II)oxid nicht zu einer Polymerisationsreaktion auf den Kupferflächen führen kann.
In diesem erfindungsgenäßen Verfahren finden als 5-gliedrige Heterocyclen Furan, Thiophen, Pyrrol oder deren Derivate Anwendung.
Als Derivate dieser Heterocyclen sind beispielsweise solche zu nennen, die in den Positionen 3 oder 4 oder 3 und 4 und/oder am Heteroatom einen oder zwei Alkyl- oder Alkenylreste tragen, insbesonders solche Derivate mit einer oder zwei Methyl-, Ethyloder Propylgruppen. Es eignen sich auch halogensubstituierte Furane, Thiophene oder Pyrrole. Zu nennen sind die 3-Chlor-, 3-Brom-, 4-Chlor-, 4-Brom-, 3,4-Dichlor-und 3,4-Dibromderivate. Geeignet sind auch die den halogensubstituierten Verbindungen analogen Formyl- und Carboxyderivate, sowie als Pyrrolderivate im besonderen das N-Methyl-,N-Ethyl -, N-Vinyl-pyrrol und das 2,2'- Dipyrrol.

Es ist weiter möglich, die entsprechenden heterocyclischen Verbindungen, insbesondere Pyrrol, mit einer schwachen Säure in die entsprechenden Oligomeren zu überführen. In einer wässrigen, ggf.Lösungsvermittler enthaltenden Lösung der heterocyclischen Verbindung erfolgt der Kontakt mit der schwachen Säure. Diese Oligomerisierungsreaktion kann gegebenenfalls bei tiefen Temperaturen, bis zum Gefrierpunkt der Lösungen, durchgeführt werden. Ebenso ist es möglich, die Reaktion auch bei Raumtemperatur oder bei 50° C durchzuführen. Die jeweilige Temperatur der Oligomerisierungsreaktion beeinflußt die Leitfähigkeit des abgeschiedenen polymeren Materials und die Stabilität der Lösung.

Als Säuren für die Oligomerisierungsreaktion sind schwache Säuren einsetzbar, beispielsweise Ameisensäure, Essigsäure, Propionsäure, Buttersäure, Oxalsäure, Bernsteinsäure, Fumarsäure, Maleinsäure,Azaleinsäure, Zitronensäure, Äpfelsäure, Ascorbinsäure oder Phosphorsäure. Es eignet sich auch der Einsatz der entsprechenden Salze, die durch Hydrolyse im wässrigen System die Säuren freisetzen.

Die Konzentration an Oligomeren, Monomeren oder Gemischen verschiedener Monomeren oder Oligomer-/Monomer - Gemischen beträgt 0,1 bis 200 g / Liter, vorzugsweise 0,5 bis 50 g /Liter.

Als auf der Leiterplatte adsorbiertes Oxidationsmittel zur Durchführung des erfindungsgemäßen Verfahrens können neben Braunstein beispielsweise eingesetzt werden die Salze von Permanganat, von Manganat, Cer(IV) und/oder Perjodat.

Die Leiterplatten werden in einem oxidierend wirkenden Bad bei einem pH-Wert zwischen 1 und 14 behandelt. Dem oxidierend wirkenden Bad können auch Tenside oder andere oberflächenaktive Substanzen zugesetzt sein.

Nachdem die Leiterplatten mit dem erfindungsgemäßen Verfahren bearbeitet worden sind, kann aufgrund der elektrischen Leitfähigkeit der Polymerschicht durch Anlegen eines elektrischen Stroms Metall aus galvanischen Bädern abgeschieden werden. In diesem Zusammenhang ist besonders das galvanische Verkupfern hervorzuheben.

Die Durchführung des erfindungsgemäßen Verfahrens kann im Tauchund/oder Sprühprozess stattfinden. Das Verfahren ist besonders geeignet, wenn beispielsweise die Leiterplatten im horizontalen kontinuierlichen Durchlauf bearbeitet werden.

Das erfindungsgemäße Verfahren eignet sich auch bei der Glasfasermetallisierung. Gute Metallisierungsergebnisse können erreicht werden, wenn einer Pyrrollösung Alkaliionen zugesetzt werden. Ebenfalls gute Metallisierungsergebnisse werden durch Zusatz von p- Phenolsulfonsäure, Benzolsulfonsäure und/oder Benzoldisulfonsäure bzw. anderen Säuren mit stark polarisierbaren Anionen erreicht.

Eine Möglichkeit zur Stabilisierung einer sauren Pyrrollösung besteht in der Erzeugung von Wasserstoff in dieser Lösung. Hierzu eignet sich besonders gut die elektrolytische Erzeugung an einer Kathodenoberfläche.
Die große Bedeutung des erfindungsgemäßen Verfahrens liegt u.a. in seiner Multifunktionalität, d.h. daß bei Verwendung von Permanganat als Oxidationsmittel eine Braunsteinschicht aufgebaut wird, das die Nichtleiteroberfläche günstig aufrauht, eine sehr gute Adsorptionsschicht aus Braunstein aufbaut und gleichzeitig das Oxidationsmittel für die Polymerenbildung bereitstellt.

Das erfindungsgemäße Verfahren kann in den folgenden Verfahrensvarianten zur Durchkontaktierung von Leiterplatten eingesetzt werden:
1. Erzeugung der oxidierend wirkenden Schicht auf den nichtleitenden Bereichen der Bohrlochwand, z.B. durch Einwirkung einer alkalischen Kaliunpermanganatlösung. Dieser Behandlung können verschiedene Vorbehandlungsschritte vorangestellt sein, die z.B. der Vorbereitung der Harzoberfläche zur effizienten Bildung der Oxidationsschicht (z.B. Braunstein) dienen sollen.
2. Einwirkung der erfindungsgemäßen Lösung der Heterocyclenverbindung auf die Substratoberfläche unter Bildung der leitfähigen Polymerenschicht in einer sauren Lösung.
3. Galvanische Metallisierung. Diesem Prozessschritt können weitere Vorbehandlungsbäder vorangestellt sein, die z.B. der Kupferflächen-Reinigung dienen.
   3a.Galvanische Verkupferung ganzflächig auf der ganzen Leiterplatte bis zur Schichtdicke von ca. 5 µm. Anschließend erfolgt der Photodruck nach einer der üblichen Techniken, der Leiterbahnaufbau (Kupfer und z.B. ein Ätzresist) in den nach dem Photodruck freigelassenen Bereichen und schließlich die Entfernung des Photoresists, der Ätzvorgang und ggf. die Entfernung des Ätzresists. Diese Verfahrensfolge kann auch entsprechend den jeweiligen Anforderungen abgeändert werden.
   3b. Galvanische Verkupferung ganzflächig auf der ganzen Leiterplatte bis zur Schichtdicke von ca. 30 µm. Anschließend erfolgt der Photodruck nach einer der üblichen Techniken, der Ätzvorgang und die Entfernung des Ätzresists. Diese Verfahrensfolge kann auch entsprechend den jeweiligen Anforderungen abgeändert werden.
   3c. Vor der galvanischen Verkupferung erfolgt der Photodruck. Anschließend wird galvanisch bis zu einer Schichtdicke 30 µm metallisiert und ggf. ein Ätzresist abgeschieden. Darauf folgt die Entfernung des metallischen Ätzresists. Diese Verfahrensfolge kann entsprechend den jeweiligen Anforderungen abgeändert werden.

Unmittelbar vor der galvanischen Verkupferung wird eine Behandlung in einer Lösung, die Säure und/oder Oxidationsmittel enthält, vorgenommen, um eine ausreichende Leitfähigkeit der Polymerschicht zu erreichen. Hierzu können z.B. Schwefelsäure/Natriumpersulfat-lösungen eingesetzt werden.

Selbstverständlich sind grundsätzlich auch andere Verfahrensweisen denkbar. Die folgenden Beispiele dienen zur Erläuterung der Erfindung.

### BEISPIEL 1

### Lösung I

20 ml Pyrrol wurden in 110 ml eines Gemisches aus Ethylenglycolmonobutylether und Isopropanol gelöst und mit 70 ml Wasser und 10 g Dichloressigsäure (K = 0.0332) versetzt.

Die Lösung verfärbt sich nach wenigen Minuten von gelb nach grünlich. Ausfällungen wurden nicht beobachtet.

Eine Epoxidharzplatte wurde wie folgt behandelt:
1. Quellen in einer Lösung mit N-Methylpyrrolidon
2. Spülen mit Wasser
3. Beizen in einer alkalischen Permanganatlösung
4. Spülen in einer Standspüle mit Wasser
5. Spülen mit Wasser
6. Tauchen für 5 min. bei 20° C in Lösung I
7. Spülen mit Wasser
8. Trocknen der Platte mit Warmluft
Der elektrische Widerstand betrug 28 kOhm.

### BEISPIEL 2

Eine Epoxidharzplatte wurde wie in Beispiel 1 behandelt und nach dem Spülen in Wasser (Step 7) in einem sauren galvanischen Kupferelektrolyten verkupfert. Die Stromdichte betrug 2 A/qdm. Nach 5 Minuten war die Schicht total verkupfert.

### BEISPIEL 3

### Lösung II

20 ml Pyrrol wurden in 70 ml N-Methylpyrrolidon gelöst und mit 110 ml Wasser und 10 g Oxalsäure (K = 0.059) versetzt.

Die Lösung färbte sich nach einigen Stunden grünlich. Ausfällungen wurden nicht beobachtet.

Eine Epoxidharzplatte wurde - wie in Beispiel 1 beschrieben - vorbehandelt (1-5) und dann (Step 6) in Lösung II für 5 Minuten behandelt, gespült und getrocknet. Nach dem Trocknen betrug der Widerstand der Polypyrrolschicht 35 kOhm.

### BEISPIEL 4

Eine mit Bohrungen versehene, doppelseitig kupferkaschierte Leiterplatte wurde - wie unter Beispiel 1 beschrieben - vorbehandelt (1-5) und anschließend in Lösung II 5 Minuten lang behandelt. Nach dem Spülen in Wasser wurde die Platte für kurze Zeit galvanisch verkupfert.

Die Bohrlochwandungen waren nach nur 5 Minuten Galvanisierzeit einwandfrei verkupfert.

### BEISPIEL 5

In einer frischen Lösung, bestehend aus
25 ml Pyrrol,
15 ml Phosphorsäure (85%ig) und
950 ml Wasser

wurde auf einer Epoxidharzplatte, die mit alkalischer Kaliunpermanganatlösung vorbehandelt war, leitfähiges Polypyrrol abgeschieden.

Der Widerstand der Polymerschicht betrug 5-6 kOhm. Die Schicht konnte ohne Fehler galvanisch verkupfert werden (4A/9 dm).

### BEISPIEL 6

In einer 24 Stunden alten Lösung, bestehend aus
25 ml Pyrrol,
25 ml Phosphorsäure (85%ig) und
950 ml Wasser
wurde auf einer Epoxidharzplatte, die gemäß Beispiel 5 vorbehandelt war, Polypyrrol abgeschieden. Der Widerstand der

Polymerschicht betrug 700 kOhm. Die Schicht konnte nicht mehr galvanisch verkupfert werden.

### BEISPIEL 7

In einer Lösung, bestehend aus
25 ml Pyrrol,
25 ml Phosphorsäure (85%ig) und
950 ml Wasser
wurde an einem Edelstahlnetz elektrolytisch Wasserstoff entwickelt. (Der Anodenraum war durch einen Elektolytschlüssel getrennt).

Eine Epoxidharzplatte, die nach Beispiel 1 (bis Pos. 5) vorbehandelt war, wurde nach 48 Stunden in dieser Lösung mit Polypyrrol beschichtet.
Die Polymerschicht hatte einen Widerstand von 105 kOhm. Die galvanische Verkupferung gelang einwandfrei.

### BEISPIEL 8

In einer Lösung, bestehend aus
7,5 g Pyrrol,
990 ml Wasser und
Phosphorsäure (bis pH 2.5)
wurde auf einer Epoxidharzplatte, die nach Beispiel 1 (bis Pos. 5) vorbehandelt war, leitfähiges Polymer abgeschieden. Der Widerstand der Polymerschicht betrug 150 - 200 kOhm. Die Schicht konnte galvanisch verstärkt werden. (4A/9 dm ). Die Lösung war stabil, es konnten noch nach einer Woche gleich gut leitende Schichten erzeugt werden.

### BEISPIEL 9

In einer Lösung, bestehend aus
7,5 g Pyrrol
990 ml Wasser und
Phosphorsäure (bis pH 3,5)
wurde auf einer Epoxidharzplatte, die nach Beispiel 1 (bis Pos.5) vorbehandelt war, leitfähiges Polymer abgeschieden. Der Widerstand der Polymerschicht betrug 6500 kOhm. Die Schicht konnte nicht galvanisch verstärkt werden. Die Lösung war stabil.

### BEISPIEL 10

In einer Lösung, bestehend aus
7,5 g Pyrrol,
5,0 g Dinatriumhydrogenphosphat krist.,
5,0 g Natriumhydrogenphosphat krist.,
980 ml Wasser und
Phosphorsäure (bis pH 2,5)
wurde auf einer Epoxidharzplatte, die nach Beispiel 1 (bis Pos. 5) vorbehandelt war, Polypyrrol abgeschieden. Der Widerstand der Polymerschicht betrug 30 - 45 kOhm. Die Schicht konnte in kurzer Zeit galvanisch verkupfert werden. (4A/9 dm) In dieser Lösung konnte, ohne daß der Widerstand der Polypyrrolschicht anstieg, über 1 Woche lang leitfähiges Polymer abgeschieden werden.

### BEISPIEL 11

In einer Lösung, bestehend aus
7,5 g Pyrrol,
25,0 g Dikaliumhydrogenphosphat,
25,0 g Kaliumhydrogenphosphat,
960 ml Wasser und
Phosphorsäure (bis pH 2,5)
wurde auf einer Epoxidharzplatte, die nach Beispiel 1 (bis Pos. 5) vorbehandelt war, Polypyrrol abgeschieden. Der Widerstand der Polymerschicht betrug 10-15 kOhm. Die Schicht konnte in wenigen Minuten galvanisch verkupfert werden (4 A/qdm). Die Lösung war stabil, so daß noch nach 1 Woche Standzeit sehr gut leitende Polypyrrolschichten abgeschieden werden konnten.

### BEISPIEL 12

In einer Lösung, bestehend aus
7,5 g/l Pyrrol
Kannte bei Raumtemperatur nach einer Vorbehandlung nach Beispiel 1 (bis Pos.5) in den Bohrungen einer Leiterplatte Polypyrrol und darauf galvanisch Kupfer abgeschieden werden. Auch nach vier Tagen nach dem Ansatz dieser Lösung wurden noch gleich gute Ergebnisse hinsichtlich der Bedeckungsfähigkeit der Bohrlochwand mit Kupfer erhalten wie unmittelbar nach dem Ansatz der Lösung. Wird ein erneuter Versuch nach einer Standzeit von sechs Tagen durchgeführt, so stellt man ein schlechteres Bedeckungsergebnis fest.

### BEISPIEL 13

Derselbe Versuch wie in Beispiel 12 wurde mit der Pyrrollösung bei +5°C durchgeführt. In diesem Fall wurde auch nach zwölf Tagen noch ein gutes Metallisierungsergebnis erhalten.

## Patentansprüche

1. Verfahren zum direkten Metallisieren von Nichtleitern, bei dem an der Nichtleiteroberfläche durch In-Kontakt-Bringen einer sauren, wäßrigen Lösung von noch nicht leitfähigen Oligomeren aus der Gruppe der Pyrrole und Thiophene mit an der Nichtleiteroberfläche adsorbierten, nicht abspülbaren, aus einer Permanganat enthaltenden Lösung abgeschiedenen, Mangandioxid enthaltenden Oxidationsmitteln in einer Prozeßstufe fest haftende, unlösliche Polymerschichten abgeschieden werden, deren elektrische Leitfähigkeit ausreicht, um durch Anlegen eines elektrischen Stroms Metall aus galvanischen Bädern auf der Polymeroberfläche abzuscheiden.

2. Verfahren zum direkten Metallisieren von Nichtleitern, bei dem an der Nichtleiteroberfläche durch In-Kontakt-Bringen einer sauren, wäßrigen Lösung von noch nicht leitfähigen Monomeren oder Gemischen verschiedener Monomere aus der Gruppe der Pyrrole und Thiophene mit an der Nichtleiteroberfläche adsorbierten, nicht abspülbaren, aus einer Permanganat enthaltenden Lösung abgeschiedenen, Mangandioxid enthaltenden Oxidationsmitteln in einer Prozeßstufe fest haftende, unlösliche Polymerschichten abgeschieden werden, deren elektrische Leitfähigkeit ausreicht, um durch Anlegen eines elektrischen Stroms Metall aus galvanischen Bädern auf der Polymeroberfläche abzuscheiden.

3. Verfahren zum direkten Metallisieren von Nichtleitern, bei dem an der Nichtleiteroberfläche durch In-Kontakt-Bringen einer sauren, wäßrigen Lösung von noch nicht leitfähigen Oligomeren-/Monomeren-Gemischen aus der Gruppe der Pyrrole und Thiophene mit an der Nichtleiteroberfläche adsorbierten, nicht abspülbaren, aus einer Permanganat enthaltenden Lösung abgeschiedenen, Mangandioxid enthaltenden Oxidationsmitteln in einer Prozeßstufe fest haftende, unlösliche Polymerschichten abgeschieden werden, deren elektrische Leitfähigkeit ausreicht, um durch Anlegen eines elektrischen Stroms Metall aus galvanischen Bädern auf der Polymeroberfläche abzuscheiden.

4. Verfahren nach einem der Ansprüche 1 oder 3, dadurch gekennzeichnet, daß die löslichen Oligomere aus der Lösung des Monomeren und einer schwachen Säure in Gegenwart von Lösungsvermittlern bei tiefen Temperaturen bis zum Gefrierpunkt der Lösung gebildet werden.

5. Verfahren nach einem der vorstehenden Ansprüche, dadurch gekennzeichnet, daß Pyrrol oder deren substituierte Derivate eingesetzt werden.

6. Verfahren nach einem der vorstehenden Ansprüche, dadurch gekennzeichnet, daß die Oligomeren, Monomeren oder deren Gemische in Konzentrationen von 0,1 g/l bis 200 g/l eingesetzt werden.

7. Verfahren nach einem der vorstehenden Ansprüche, dadurch gekennzeichnet, daß die Lösung Säuren und/oder saure Salze mit einer Dissoziationskonstante in wäßriger Lösung, bezogen auf Protonen, zwischen 0,1 und 0,01 enthält.

8. Verfahren nach einem der vorstehenden Ansprüche, dadurch gekennzeichnet, daß als galvanisches Bad ein saures Kupferbad eingesetzt wird.

9. Verfahren nach einem der Ansprüche 4 - 8, dadurch gekennzeichnet, daß als Lösungsvermittler organische Lösungsmittel mit ausgeprägtem polaren Verhalten verwendet werden.

10. Verfahren nach einem der vorstehenden Ansprüche, dadurch gekennzeichnet, daß die Lösungen und/oder Bäder durch Tauchen und/oder Sprühen mit den Nichtleitern in Kontakt gebracht werden.

11. Verfahren nach einem der vorstehenden Ansprüche, dadurch gekennzeichnet, daß die Lösungen und/oder Bäder in horizontalen, kontinuierlichen Durchlaufanlagen mit den Nichtleitern in Kontakt gebracht werden.

12. Verfahren zur Metallisierung von nichtleitenden Bohrlochwänden in Leiterplatten nach einem der vorstehenden Ansprüche.

13. Verfahren nach Anspruch 12, dadurch gekennzeichnet, daß die galvanische Metallisierung nach der Erstellung des Leiterbildes, die sich an die Bildung der leitfähigen Polymerschicht anschließt, durchgeführt wird und daß die leitfähige Polymerschicht unmittelbar vor der galvanischen Metallisierung mit einer Lösung behandelt wird, die Säure und/oder Oxidationsmittel enthält.

14. Verfahren nach einem der vorhergehenden Ansprüche, dadurch gekennzeichnet, daß an der Nichtleiteroberfläche als nicht abspülbare adsorbierte Oxidationsmittel anstelle von Mangandioxid andere Salze von Permanganat, Cer (IV) oder Perjodat verwendet werden.

## Claims

1. Method of directly metallising non-conductors, wherein firmly adherent, insoluble polymer layers are deposited on the non-conductor surface by bringing an acidic, aqueous solution of not yet conductive oligomers selected from the group of pyrroles and thiophenes into contact with unrinsable oxidising agents, which contain manganese dioxide, said oxidising agents being adsorbed on the non-conductor surface and separated from a solution containing permanganate, in a processing stage, the electrical conductivity of said layers being sufficient to deposit metal from electroplating baths on the polymer surface by applying an electric current.

2. Method of directly metallising non-conductors, wherein firmly adherent, insoluble polymer layers are deposited on the non-conductor surface by bringing an acidic, aqueous solution of not yet conductive monomers or mixtures of various monomers selected from the group of pyrroles and thiophenes into contact with unrinsable oxidising agents, which contain manganese dioxide, said oxidising agents being adsorbed on the non-conductor surface and separated from a solution containing permanganate, in a processing stage, the electrical conductivity of said layers being sufficient to deposit metal from electroplating baths on the polymer surface by applying an electric current.

3. Method of directly metallising non-conductors, wherein firmly adherent, insoluble polymer layers are deposited on the non-conductor surface by bringing an acidic, aqueous solution of not yet conductive mixtures of oligomers and monomers selected from the group of pyrroles and thiophenes into contact with unrinsable oxidising agents, which contain manganese dioxide, said oxidising agents being adsorbed on the non-conductor surface and separated from a solution containing permanganate, in a processing stage, the electrical conductivity of said layers being sufficient to deposit metal -from electroplating baths on the polymer surface by applying an electric current.

4. Method according to one of claims 1 or 3, characterised in that the soluble oligomers are formed from the solution of the monomer and a weak acid in the presence of solubilisers at low temperatures as far as the freezing point of the solution.

5. Method according to one of the preceding claims, characterised in that pyrrole or its substituted derivatives are used.

6. Method according to one of the preceding claims, characterised in that the oligomers, monomers or their mixtures are used in concentrations from 0.1 g/l to 200 g/l.

7. Method according to one of the preceding claims, characterised in that the solution contains acids and/or acidic salts having a dissociation constant in aqueous solution, relative to protons, between 0.1 and 0.01.

8. Method according to one of the preceding claims, characterised in that an acidic copper bath is used as the electroplating bath.

9. Method according to one of claims 4 - 8, characterised in that organic solvents, having an excellent polar behaviour, are employed as the solubilisers.

10. Method according to one of the preceding claims, characterised in that the solutions and/or baths are brought into contact with the non-conductors by immersion and/or spraying.

11. Method according to one of the preceding claims, characterised in that the solutions and/or baths are brought into contact with the non-conductors in horizontal, continuous throughfeed systems.

12. Method of metallising non-conductive walls of bores drilled in printed circuit boards according to one of the preceding claims.

13. Method according to claim 12, characterised in that the electroplating is accomplished after the creation of the conductive pattern, which creation is subsequent to the formation of the conductive polymer layer, and in that the conductive polymer layer is treated with a solution, which contains acid and/or oxidising agents, immediately prior to the electroplating.

14. Method according to one of the preceding claims, characterised in that, instead of manganese dioxide, other salts of permanganate, cerium (IV) or periodate are employed on the non-conductor surface as the unrinsable, adsorbed oxidising agents.

## Revendications

1. Procédé de métallisation directe de non-conducteurs, dans lequel, dans une étape de procédé, on dépose sur la surface non conductrice, par mise en contact d'une solution aqueuse acide d'oligomères non encore conducteurs du groupe des pyrroles et des thiophènes avec des agents oxydants contenant du dioxyde de manganèse adsorbés sur la surface non conductrice, non lavables, déposés à partir d'une solution contenant du permanganate, des couches de polymères insolubles adhérentes dont la conductibilité électrique est suffisante pour déposer du métal à partir de bains galvaniques sur la surface du polymère lorsqu'on applique un courant.

2. Procédé de métallisation directe de non-conducteurs, dans lequel, dans une étape de procédé, on dépose sur la surface non conductrice, par mise en contact d'une solution aqueuse acide de monomères ou mélanges de différents monomères non encore conducteurs du groupe des pyrroles et des thiophènes avec des agents oxydants contenant du dioxyde de manganèse adsorbés sur la surface non conductrice, non lavables, déposés à partir d'une solution contenant du permanganate, des couches de polymères insolubles adhérentes dont la conductibilité électrique est suffisante pour déposer du métal à partir de bains galvaniques sur la surface du polymère lorsqu'on applique un courant.

3. Procédé de métallisation directe de non-conducteurs, dans lequel, dans une étape de procédé, on dépose sur la surface non conductrice, par mise en contact d'une solution aqueuse acide de mélanges d'oligomères/monomères non encore conducteurs du groupe des pyrroles et des thiophènes avec des agents oxydants contenant du dioxyde de manganèse adsorbés sur la surface non conductrice, non lavables, déposés à partir d'une solution contenant du permanganate, des couches de polymères insolubles adhérentes dont la conductibilité électrique est suffisante pour déposer du métal à partir de bains galvaniques sur la surface du polymère lorsqu'on applique un courant.

4. Procédé selon l'une des revendications 1 ou 3, caractérisé en ce que les oligomères solubles sont formés à partir de la solution du monomère et d'un acide faible en présence de promoteurs de dissolution à des températures basses allant jusqu'au point de congélation de la solution.

5. Procédé selon l'une des revendications précédentes, caractérisé en ce que l'on utilise le pyrrole ou les dérivés substitués de celui-ci.

6. Procédé selon l'une des revendications précédentes, caractérisé en ce que l'on utilise les oligomères, les monomères ou les mélanges de ceux-ci à des concentrations de 0,1 g/l à 200 g/l.

7. Procédé selon l'une des revendications précédentes, caractérisé en ce que la solution contient des acides et/ou des sels acides ayant une constante de dissociation en solution aqueuse, ramenée aux protons, de 0,1 à 0,01.

8. Procédé selon l'une des revendications précédentes, caractérisé en ce que l'on utilise comme bain galvanique un bain de cuivre acide.

9. Procédé selon l'une des revendications 4 à 8, caractérisé en ce que l'on utilise comme promoteur de dissolution un solvant organique ayant un comportement polaire marqué.

10. Procédé selon l'une des revendications précédentes, caractérisé en ce que les solutions et/ou les bains sont mis en contact avec les non-conducteurs par trempage et/ou par pulvérisation.

11. Procédé selon l'une des revendications précédentes, caractérisé en ce que les solutions et/ou les bains sont mis en contact avec les non-conducteurs dans des installations en continu à passage horizontal.

12. Procédé de métallisation de parois de trous non conducteurs dans des circuits imprimés selon l'une des revendications précédentes.

13. Procédé selon la revendication 12, caractérisé en ce que la métallisation galvanique s'effectue après la réalisation du motif conducteur consécutive à la formation de la couche de polymère conducteur et en ce que la couche de polymère conducteur est traitée juste avant la métallisation galvanique avec une solution contenant de l'acide et/ou de l'agent oxydant.

14. Procédé selon l'une des revendications précédentes, caractérisé en ce que, à la place du dioxyde de manganèse, on utilise comme agent oxydant adsorbé non lavable sur la surface non conductrice d'autres sels de permanganate, de cérium (IV) ou de periodate.
